# EUROPÄISCHE PATENTSCHRIFT

(11) **EP 4 487 661 B1**
(45) Veröffentlichungstag und Bekanntmachung des Hinweises auf die Patenterteilung: **01.04.2026**
(21) Anmeldenummer: 23704118.1
(22) Anmeldetag: 07.02.2023
(51) Int. Cl.: H05K 7/14

(54) **MODULARES FELDGERÄT**
MODULAR FIELD DEVICE
DISPOSITIF DE TERRAIN MODULAIRE

(30) Priorität: 28.02.2022 DE 102022104763
(43) Veröffentlichungstag der Anmeldung: 08.01.2025
(73) Patentinhaber: Endress+Hauser SE+Co. KG, 79689 Maulburg (DE)
(72) Erfinder: SCHMIDT, Robert, 79650 Schopfheim (DE)
(74) Vertreter: Endress + Hauser Group Services (Deutschland) AG+Co. KG
(86) Internationale Anmeldenummer: PCT/EP2023/052976
(87) Internationale Veröffentlichungsnummer: WO 2023/161015

(56) Entgegenhaltungen:
- EP-B1- 2 841 899
- DE-A1- 102008 049 232
- DE-A1- 102020 101 085

## Beschreibung

Die Erfindung betrifft ein modulares Feldgerät mit den Merkmalen des Oberbegriffs des ersten Anspruchs, das einfach und sicher fertigbar ist.

In der Automatisierungstechnik, beispielsweise in groß-industriellen Prozess-Anlagen, werden vielfach Feldgeräte eingesetzt, die zur Erfassung der relevanten Prozessparameter von Prozessmedien dienen. Zur Erfassung der Prozessparameter werden geeignete Messprinzipien eingesetzt. Entsprechende Sensoren kommen unter anderem in Grenzstandmessgeräten, Füllstandsmessgeräten, Durchflussmessgeräten, Druck- und Temperaturmessgeräten, pH-Redoxpotential-Messgeräten, Leitfähigkeitsmessgeräten, usw. zum Einsatz. Sie erfassen in den Behältern oder Rohren, in denen sich das Prozessmedium befindet, die jeweiligen Prozessparameter, wie den Füllstand, den Durchfluss, den Druck, die Temperatur, den pH-Wert, das Redoxpotential, die Leitfähigkeit oder den Dielektrizitätswert. Eine Vielzahl dieser Feldgeräte wird von der Firma Endress + Hauser hergestellt und vertrieben.

Zunehmend werden Feldgeräte modular ausgelegt. Dabei bedeutet modulare Auslegung im Fall von Feldgeräten, dass verschiedene Feldgeräte-Typen, wie beispielsweise Druckmessgeräte, Grenzstandmessgeräte und Füllstandsmessgeräte, zum Teil aus identischen Modulen bzw. Komponenten aufgebaut werden. Vorteilhaft ist die Verwendung identischer Komponenten bei verschiedenen Feldgeräte-Typen vor allem im Falle derjenigen Elektronik-Module, die übergeordnete Funktionen wie beispielsweise Kommunikation oder Messdaten-Verarbeitung ausüben. Somit kann bei der Entwicklung und der Fertigungs-Logistik neuer Feldgeräte-Typen durch eine modulare Auslegung einzelner Komponenten eine wesentliche Kostenreduktion bewirkt werden.

Allerdings kann durch die modulare Auslegung eines Feldgeräte-Typs dessen Montage erschwert werden, da sich die Anzahl an Komponenten, insbesondere von Elektronik-Modulen, bei gleichbleibendem Platzangebot im Gehäuse-Inneren des Feldgerätes erhöht. Gleichzeitig müssen die einzelnen Elektronik-Module sowohl untereinander als auch zum Gehäuse-Inneren hin elektrisch bzw. mechanisch kontaktiert werden. Somit wird durch die komplexere Einbausituation die eigentliche Fertigung des Feldgerätes schwieriger. In der internationalen Veröffentlichungsschrift WO 2019/038266 A1 ist zwar ein Feldgerät gezeigt, bei dem zwei Elektronik-Module mechanisch miteinander verbindbar sind und dementsprechend platzsparend im Inneren eines Gehäuses angeordnet werden können. Eine geeignete, elektrische Kontaktierung der zwei Elektronik-Module untereinander wird jedoch nicht beschrieben.

Die DE 10 2020 101 085 A1 offenbart eine Vorrichtung zum Verarbeiten von Signalen, die zwischen einer Steuerung und einem Feldgerät übertragen werden. Dabei sind auf einem Träger Steckplätze zur elektrischen und mechanischen Verbindung von Modulen vorhanden. Über Tulpenkontakte werden die Leiterbahnen der Module kontaktiert.

Die DE 10 2008 049 232 A1 offenbart eine Aufnahmeeinheit, in die ein Schaltungsträger über eine Drehbewegung eingebracht werden kann.

Der Erfindung liegt daher die Aufgabe zugrunde, ein modulares Feldgerät bereitzustellen, das sowohl mechanisch als auch elektrisch einfach und sicher fertigbar ist.

Die Erfindung löst diese Aufgabe durch ein Feldgerät mit den Merkmalen des ersten Anspruchs.

Die Auslegung der mechanischen Befestigung an den Elektronik-Modulen ist im Rahmen der Erfindung nicht fest vorgegeben, sie kann zur Befestigung beispielsweise drei gleichverteilte Einrast-Laschen und entsprechende Vorsprünge umfassen.

Vorteilhaft an der erfindungsgemäßen Auslegung des elektrischen Steckkontaktes ist, dass beim Befestigen der elektronischen Module aneinander sowie beim vorherigen Einstecken der ersten Leiterplatte in die erste Führung keine Kraft auf die Lötstellen zwischen der ersten Leiterplatte und der darauf befindlichen Buchsen- oder Stecker-Anordnung ausgeübt wird.

Unter dem Begriff "*Modul*" wird im Rahmen der Erfindung prinzipiell eine separate Anordnung bzw. Kapselung derjenigen elektronischen Schaltungen verstanden, die für einen konkreten Einsatzzweck, bspw. zur Messsignal-Verarbeitung oder als Schnittstelle vorgesehen sind. Das jeweilige Modul kann also je nach Einsatzzweck entsprechende Analogschaltungen zur Erzeugung bzw. Verarbeitung analoger Signale umfassen. Das Modul kann jedoch auch Digitalschaltungen, wie FPGA's, Microcontroller oder Speichermedien in Zusammenwirken mit entsprechenden Programmen umfassen. Dabei ist das Programm ausgelegt, die erforderlichen Verfahrensschritte durchzuführen bzw. die notwendigen Rechenoperationen anzuwenden. In diesem Kontext können verschiedene elektronische Schaltungen der Einheit im Sinne der Erfindung potenziell auch auf einen gemeinsamen physikalischen Speicher zurückgreifen bzw. mittels derselben physikalischen Digitalschaltung betrieben werden. Dabei ist es nicht relevant, ob verschiedene elektronische Schaltungen innerhalb des Moduls auf einer gemeinsamen Leiterkarte oder auf mehreren, verbundenen Leiterkarten angeordnet sind.

Sofern dasjenige Elektronik-Modul, an welchem die Leiterplatten-Aufnahme angeordnet ist, auf einer zweiten Leiterplatte basiert, welche orthogonal zum Einsteck-Vektor ausgerichtet ist, muss die Leiterplatten-Aufnahme bzw. die entsprechende Buchsen- oder Stecker-Anordnung in Bezug zum Einsteck-Vektor hinter bzw. oberhalb der zweiten Leiterplatte angeordnet sein, damit der elektrische Steckkontakt geschlossen werden kann. Eine günstige Weiterentwicklung besteht in diesem Fall darin, dass die Leiterplatten-Aufnahme als insbesondere integraler Bestandteil eines Vergussrahmens für die zweite Leiterplatte ausgelegt ist. Dies reduziert die Anzahl erforderlicher Komponenten.

Vorteilhaft ist es außerdem, wenn die erfindungsgemäße Leiterplatten-Aufnahme auf Seiten derjenigen Oberfläche der ersten Leiterplatte, auf welcher die entsprechende Anordnung angeordnet ist, einen orthogonal zum Einsteck-Vektor verlaufenden Bügel aufweist. Sofern in diesem Fall die erste Leiterplatte elektrisch über eine flexible Leiterkarte oder ein flexibles Kabel mit der zweiten Leiterplatte verbunden ist, kann das Kabel bei der Fertigung in Form einer definierten Schlaufe um den Bügel herumgeführt werden. Hierdurch wird das Kabel bzw. die flexible Leiterkarte ausreichend fixiert, um nicht mehr beschädigt werden zu können. Außerdem kann der Bügel konstruktiv so ausgelegt werden, dass es in der Leiterplatten-Aufnahme eine Innenfläche umschließt, welche kleiner als der minimal mögliche Umfang der entsprechenden Anordnung auf der ersten Leiterplatte ist. Dies verhindert ein Einschieben der ersten Leiterplatte in die erste Führung von der falschen Seite.

Um die erste Leiterplatte in der Leiterplatten-Aufnahme in Richtung des Einsteck-Vektors zu fixieren, kann gegenüberliegend zu derjenigen Oberfläche der ersten Leiterplatte, auf welcher die entsprechende Anordnung angeordnet ist, ein Einrast-Haken vorgesehen werden. In diesem Fall bildet der Einrast-Haken für die erste Leiterplatte nach Einrasten in der ersten Führung in Richtung des Einsteck-Vektors einen entsprechenden Endanschlag aus. Vor allem bei solch einer Auslegung mit Einrast-Haken ist es vorteilhaft, wenn die Leiterplatten-Aufnahme eine zweite Führung ausbildet, welche die entsprechende Stecker- bzw. Buchsen-Anordnung in Bezug zur Oberfläche der ersten Leiterplatte orthogonal führt. Hierdurch wird das Einrasten vereinfacht. Außerdem ist es vorteilhaft, wenn der Einrast-Haken im eingerasteten Zustand orthogonal zur Oberfläche der ersten Leiterplatte eine Druckkraft auf die erste Leiterplatte ausübt. Hierdurch wird die erste Leiterplatte innerhalb der ersten Führung trotz etwaigem Übermaß in einer definierten Position fixiert, sodass das Schließen des Steckkontaktes vereinfacht wird.

Anhand nachfolgender Figuren wird die Erfindung näher erläutert: Dabei zeigen:
Fig. 1: ein vibronisches Grenzstandmessgerät an einem Behälter,
Fig. 2: eine Schnittansicht des erfindungsgemäßen Grenzstand-Messgerätes,
Fig. 3: die Befestigung der zwei Elektronik-Module des erfindungsgemäßen Grenzstandmessgerätes aneinander als Explosionsansicht,
Fig. 4: das zweite Elektronik-Modul mit erfindungsgemäßer Leiterplatten-Aufnahme und
Fig. 5: zwei Detail-Ansichten im Bereich der Leiterplatten-Aufnahme zur elektrischen Kontaktierung der zwei Elektronik-Module.

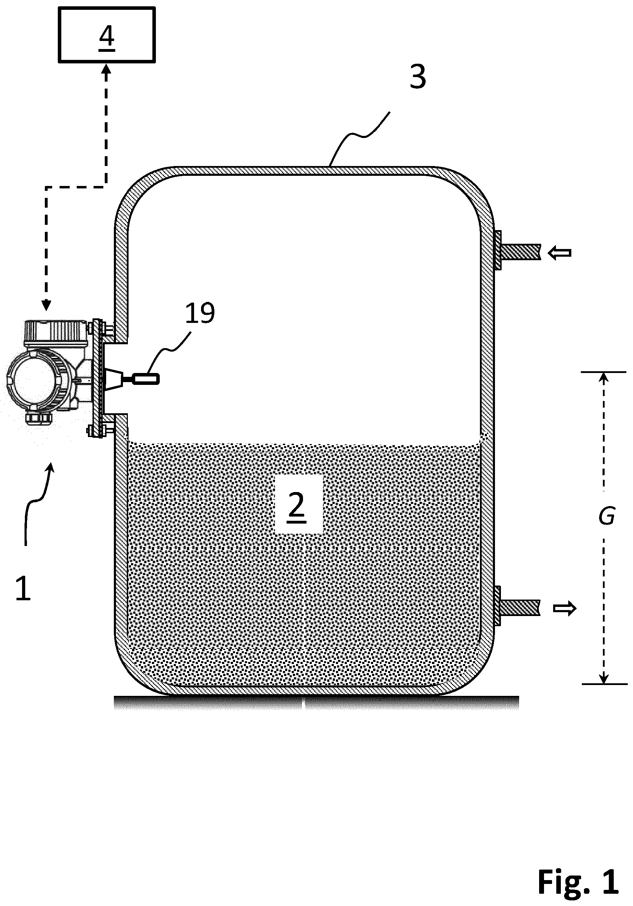

Nachfolgend wird die erfindungsgemäße Idee anhand von vibronischer Grenzstand-Detektion näher erläutert. Zum prinzipiellen Verständnis der Erfindung ist in Fig. 1 daher ein Behälter 3 einer industriellen Prozessanlage mit einem Füllgut 2 gezeigt, wobei ein etwaiges Erreichen eines Grenzstandes G des Füllgutes 2 zu bestimmen ist, beispielsweise, um Zu- oder Abläufe am Behälter 3 zu steuern. Dabei kann der Behälter 3 je nach Art des Füllgutes 2 und je nach Einsatzgebiet bis zu mehr als 100 m hoch sein. Von der Art des Füllgutes 2 und dem Einsatzgebiet hängen auch die Bedingungen im Behälter 3 ab. So kann es im Falle von exothermen Reaktionen beispielsweise zu hoher Temperatur- und Druckbelastung kommen. Bei staubhaltigen oder entzündlichen Stoffen sind im Behälter-Inneren entsprechende Explosionsschutzbedingungen einzuhalten. Zur Bestimmung des Grenzstandes G ist an einer äußeren Seitenwand des Behälters 3 auf Höhe des zu erfassenden Grenzstandes G ein Feldgerät 1 in Form eines vibronischen Grenzstandmessgerätes 1 derart angeordnet, dass lediglich einen mechanisch schwingfähiger Körper 19, wie eine Schwinggabel, in das Innere des Behälters 3 absteht. Als Anschluss für das Grenzstandmessgerät 1 am Behälter 3 kann beispielsweise ein Flanschanschluss fungieren. Dabei wird bezüglich des allgemeinen Funktionsprinzips vibronischer Grenzstandmessung exemplarisch auf die Veröffentlichungsschrift DE 10 2010 040 219 A1 verwiesen.

In der Regel ist das Grenzstandmessgerät 1 über eine separate Schnittstelle, wie etwa "4-20 mA", "PROFIBUS", "HART", oder "Ethernet" mit einer übergeordneten Einheit 4, wie z. B. einem lokalen Prozessleitsystem oder einem dezentralen Server-System verbunden. Hierüber kann ein etwaig detektierter Grenzstand G übermittelt werden, um beispielsweise die etwaigen Zu- oder Abflüsse des Behälters 3 zu steuern. Es können aber auch anderweitige Informationen über den allgemeinen Betriebszustand des Grenzstandmessgerätes 1 kommuniziert werden.

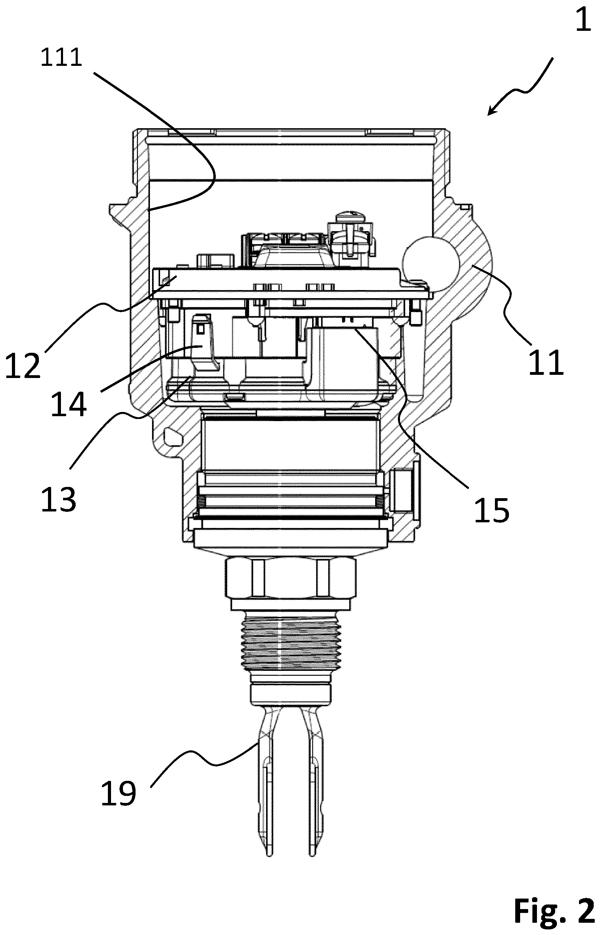

Wie aus der Querschnittsansicht des Grenzstandmessgerätes 1 in Fig. 2 hervorgeht, sind die elektronischen Komponenten auf zwei Module 12, 13 aufgeteilt, um das Grenzstandmessgerät 1 Plattformbasis fertigen zu können. Dabei umfasst das erste Elektronik-Modul 12 diejenigen, elektronischen Komponenten zur Kommunikation mit der übergeordneten Einheit 4, welche auch in anderen Feldgeräte-Typen einsetzbar sind. Das zweite Elektronik-Modul 13 umfasst die zur Grenzstandbestimmung spezifischen elektrischen Komponenten. Die Querschnittsansicht des Grenzstandmessgerätes 1 in Fig. 2 verdeutlicht, dass die zwei Elektronik-Module 12, 13 gemeinsam in einem Innenraum 111 eines Gehäuse 11 des Grenzstandmessgerätes 1 angeordnet sind, welches sich nach Montage des Grenzstandmessgerätes 1 am Einsatzort außerhalb des Behälters 3 befindet. Die Schwinggabel 19 schließt sich wiederum derart über ein Gewinde an das Gehäuse 11 an, sodass die Schwinggabel 19 nach Montage in das Behälter-Innere absteht. Das erste Elektronik-Modul 12 wird im Innenraum 111 des Grenzstandmessgerätes 1 an einem umlaufenden Vorsprung befestigt, beispielsweise mittels Schraubverbindungen. Das zweite Elektronik-Modul 13 ist nicht direkt im Innenraum 111 befestigt, sondern lediglich indirekt, indem das zweite Elektronik-Modul 13 am ersten Elektronik-Modul 12 befestigt wird.

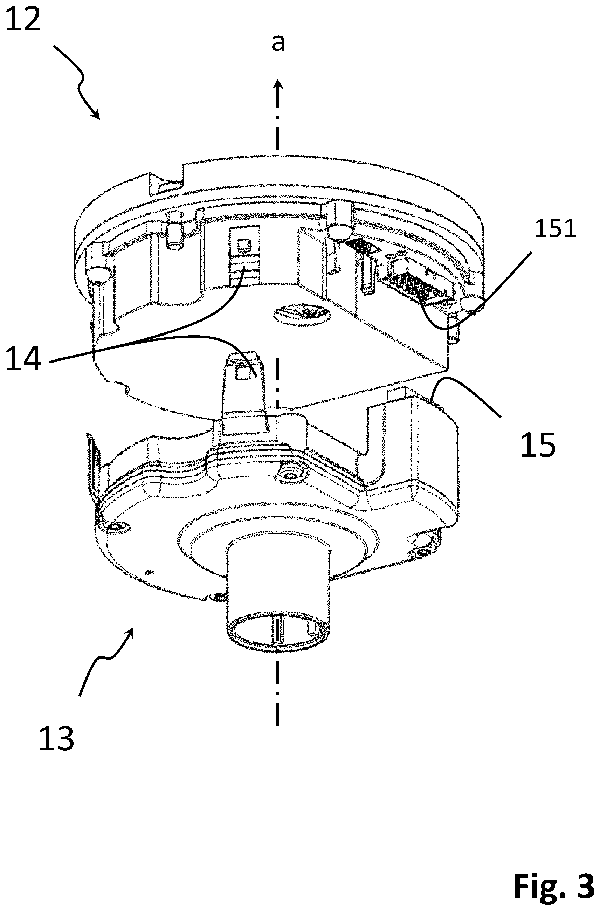

Wie das zweite Elektronik-Modul 13 am ersten Elektronik-Modul 12 befestigt wird, kommt in Fig. 3 zur Geltung: Die mechanische Befestigung 14 der Elektronik-Module 12, 13 aneinander erfolgt im gezeigten Ausführungsbeispiel über drei zweite Einrast-Laschen 141a, b, c am zweiten Elektronik-Modul 13 sowie entsprechenden Vorsprünge am ersten Elektronik-Modul 12. Dabei sind die drei Einrast-Laschen 141a, b, c in Bezug zu einem Einsteck-Vektor a über jeweils 120° gleichverteilt zueinander derart angeordnet, dass das zweite Elektronik-Modul 13 in Richtung des Einsteck-Vektors a am ersten Elektronik-Modul 12 einrastbar ist.

Wie aus der Explosionsansicht in Fig. 3 hervorgeht, ist das zweite Elektronik-Modul 13 nicht nur mechanisch, sondern auch elektrisch mit dem ersten Elektronik-Modul 12 verbunden, und zwar über einen Steckkontakt 15. Hierzu umfasst der Steckkontakt 15 auf Seiten des ersten Elektronik-Moduls 12 eine Stecker-Anordnung 151, die entgegen der Einsteck-Achse a ausgerichtet ist. Das zweite Elektronik-Modul 13 umfasst eine zur Stecker-Anordnung 151 entsprechende Buchsen-Anordnung 152. Dabei ist der Steckkontakt 15 korrespondierend zu den Einrast-Laschen 141a, b, c bzw. den Vorsprüngen ausgelegt. Das heißt, sofern die Einrast-Laschen 141a, b, c am zweiten Elektronik-Modul 13 in Bezug zum Einsteck-Vektor a passend zu den entsprechenden Vorsprüngen am ersten Elektronik-Modul 12 ausgereichtet sind, stimmt in Bezug zur Einsteck-Vektor a auch automatisch die Position der Stecker-Anordnung 151 mit der Position der Buchsen-Anordnung 152 überein. Hierdurch lassen sich die zwei Elektronik-Module 12, 13 gleichzeitig elektrisch und mechanisch miteinander verbinden, indem die Einrast-Laschen 141a, b, c zu den Vorsprüngen (bzw. die Stecker-Anordnung 151 zu der Buchsen-Anordnung 152) in Bezug zum Einsteck-Vektor a fluchtend ausgerichtet werden, sodass die Module 12, 13 im Anschluss entlang des Einsteck-Vektors a zusammengesteckt werden können. Hierbei dienen die Einrast-Laschen 141a, b, c gleichzeitig als Führung.

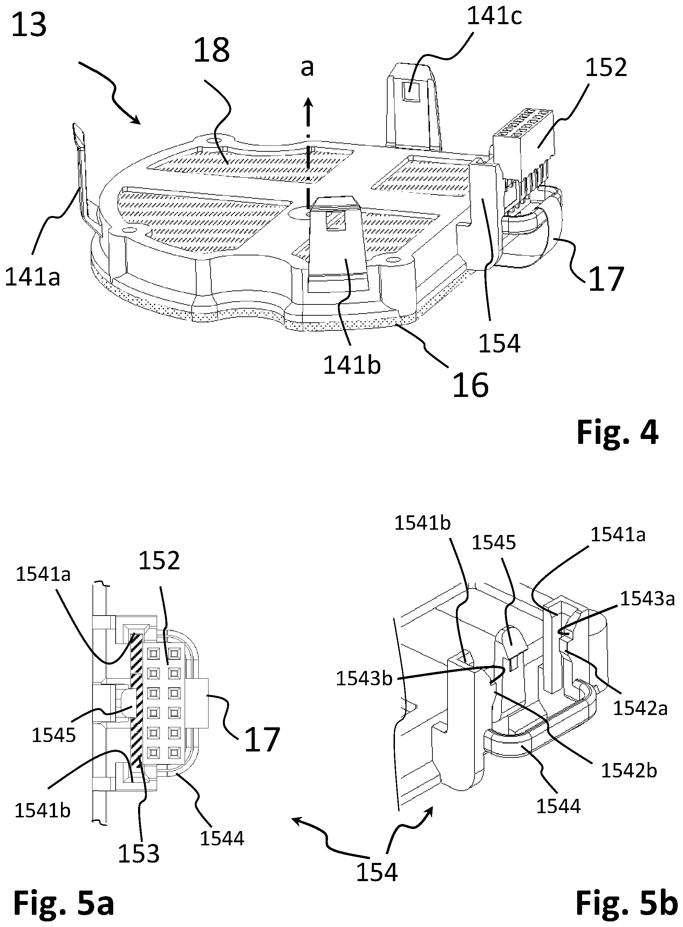

Näher verdeutlicht wird der erfindungsgemäße, elektrische Steckkontakt 15 anhand von Fig. 4, welche ausschließlich das zweite Elektronik-Modul 13 zeigt: In der gezeigten Ausführungsvariante basiert das zweite Elektronik-Modul 13 auf einer zweiten Leiterplatte 16, wobei der Einsteck-Vektor a orthogonal zur zweiten Leiterplatte 16 verläuft. Aufgrund von Feldgeräte-spezifischen Explosionsschutz-Vorgaben wird die zweite Leiterplatte 16 durch einen Weichverguss 18, beispielsweise SILGel^{®}, gekapselt. Dabei umfasst der entsprechende Vergussrahmen auf der Leiterplatte 16 eine Aufnahme 154 für die Buchsen-Anordnung 152 des elektrischen Steckkontaktes 15. Da die Buchen-Anordnung 152 bzw. die Stecker-Anordnung 151, wie gezeigt, in der Regel als SMD-Bauteil oder als THT-Bauteil realisiert sind, fixiert die Aufnahme 154 jedoch vorwiegend nicht die Buchsen-Anordnung 152, sondern in erster Linie diejenige erste Leiterplatte 153, auf welcher die Buchsen-Anordnung 152 verlötet ist: Dabei ist die Buchsen-Anordnung 152 derart auf der ersten Leiterplatte 153 angeordnet, sodass deren Buchsen orthogonal zu derjenigen Leiterplatten-Oberfläche, auf welcher die Buchsen-Anordnung 152 verlötet ist, bzw. parallel zum Einsteck-Vektor a ausgerichtet sind.

Wie aus Fig. 4 außerdem hervorgeht, ist es konstruktiv notwendig, dass die Leiterplatten-Aufnahme 154 bzw. die Buchsen-Anordnung 152 in Bezug zum Einsteck-Vektor a hinter bzw. oberhalb der zweiten Leiterplatte 16 auf Höhe der Einrast-Laschen 141a, b, c angeordnet ist, damit der elektrische Steckkontakt 15 geschlossen werden kann. Elektrisch verbunden ist die Buchsen-Anordnung 152 bzw. die erste Leiterplatte 153 mit der zweiten Leiterplatte 16 in der gezeigten Ausführungsvariante über eine flexible Leiterkarte 17. Zu Fertigungszwecken ist es dabei notwendig, dass die flexible Leiterkarte 17 ein definiertes Übermaß an Länge aufweist, damit die erste Leiterplatte 153 bei der Fertigung des Grenzstandmessgerätes 1 entgegen des Einsteck-Vektors a in Führungs-Nuten 1541a, b einer ersten Führung der Leiterplatten-Aufnahme einsatzbar ist. Zwei Detail-Ansichten der Leiterplatten-Aufnahme 154, die dies im Detail zeigt, ist in Fig. 5a und Fig. 5b gezeigt:
Erfindungsgemäß bildet die Leiterplatten-Aufnahme 154 die zwei gegenüberliegenden Führungs-Nuten 1541a, b für die erste Leiterplatte 153 als integralen Bestandteil aus. Um die erste Leiterplatte 153 nach Einsetzen in die Nuten 1541a, b entgegen des Einsteck-Vektors a zu fixieren, bildet die Leiterplatten-Aufnahme 154 in diese Richtung an den zwei Nuten 1541a, b erfindungsgemäß außerdem zwei entsprechende Endanschlags-Elemente 1542a, b für die Buchsen-Anordnung 152 aus. Vorteilhaft hieran ist, dass beim Befestigen der Elektronik-Module 12, 13 aneinander bzw. beim Verbinden des Steckkontaktes 14 sowie beim vorherigen Einstecken der ersten Leiterplatte 153 in die Führungs-Nuten 1541a, b keine Kraft auf die Lötstellen zwischen der ersten Leiterplatte 153 und
der Buchsen-Anordnung 152 ausgeübt wird. In entgegengesetzter Richtung, also in Richtung des Einsteck-Vektors a wird die erste Leiterplatte 153 nach Einschieben der ersten Leiterplatte 153 in die Nuten 1541a, b bis zu den Endanschlags-Elementen 1543a, b durch einen entsprechenden Einrast-Haken 1545 fixiert, wie insbesondere in Fig. 5b zu erkennen ist.

Wie aus Fig. 5b deutlich wird, ist der Einrast-Haken 1545 gen erster Leiterplatte 153 zudem derart verdickt, sodass er die erste Leiterplatte 153 im eingerasteten Zustand in etwa orthogonal zu ihrer Oberfläche vom Einrast-Haken 1545 wegdrückt. Hierdurch besitzt die erste Leiterplatte 153 - und somit die Buchsen-Anordnung 152 - im eingerasteten Zustand eine definierte Position innerhalb der Führungs-Nuten 1541a, b. Die Verdickung am Einrast-Haken 1545 vereinfacht somit das Schließen des elektrischen Kontaktes 15 beim Befestigen der zwei Elektronik-Module 12, 13 aneinander. Außerdem bilden die zwei Endanschlags-Elemente 1543a, b für die Buchsen-Anordnung 152 quasi eine zweite Führung 1543a, b für die Buchsen-Anordnung 152 aus: Hierdurch wird die Buchsen-Anordnung 152 mitsamt der ersten Leiterplatte 153 in Bezug zur Oberfläche der ersten Leiterplatte 153 orthogonal geführt, also quasi parallel zur zweiten Leiterplatte 16. Dabei versteht es sich von selbst, dass eine Führung nur im Toleranzbereich der Führungs-Nuten 1543 zur Dicke der ersten Leiterplatte 153 möglich ist. Dies unterstützt die erste Leiterplatte 153 beim Einrasten in den Einrast-Haken 1545.

Weiterhin umfasst die Leiterplatten-Aufnahme 154 bei der in Fig. 4 und Fig. 5 gezeigten Ausführungsvariante auf Seiten derjenigen Oberfläche der ersten Leiterplatte 153, auf welcher die Buchsen Anordnung 152 angeordnet ist, als integralen Bestandteil einen orthogonal zum Einsteck-Vektor a verlaufenden Bügel 1544. Durch den Bügel 1544 bildet die flexible Leiterkarte 17 beim Einsetzen der ersten Leiterplatte 153 in die erste Führung 1541a, b eine definierte Schlaufe um den Bügel 1544 herum aus. Hierdurch ist die flexible Leiterkarte 17 zur nachfolgenden Fertigung des Grenzstandmessgerätes 1 entsprechend fixiert und kann nicht versehentlich beschädigt werden. Weiterhin ist der Bügel 1544 in der gezeigten Ausführung so ausgelegt, dass diejenige Innenfläche, die vom Bügel 1544 in der Leiterplatten-Aufnahme 154 umschlossen wird, kleiner als der minimale denkbare Umfang der Buchsen-Anordnung 152 ist. Hierdurch ist es ausgeschlossen, dass versucht wird, die erste Leiterplatte 153 bzw. die Buchsen-Anordnung 152 bei der Fertigung des Grenzstandmessgerätes 1 fälschlicherweise in Richtung des Einsteck-Vektors a in die erste Führung 1541a, b einzusetzen.

Bei der in Fig. 3 - Fig. 5 gezeigten Ausführungsvariante des erfindungsgemäßen Grenzstandmessgerätes 1 ist die Buchsen-Anordnung 152 am zweiten Elektronik-Modul 13 angeordnet, während die korrespondierende Stecker-Anordnung 151 am ersten Elektronik-Modul 12 angeordnet ist. Diesbezüglich ist es im Sinne der Erfindung selbstverständlich, dass die Anordnungen 151, 152 auch umgekehrt an den Modulen 12, 13 anordbar sind. Das heißt, die Buchsen-Anordnung 152 ist am ersten Elektronik-Modul 12 angeordnet, während die Stecker-Anordnung 151 am zweiten Elektronik-Modul 13 bzw. der ersten Leiterplatte 153 konzipiert ist.

### Bezugszeichenliste

- 1: Feldgerät
- 2: Füllgut
- 3: Behälter
- 4: Übergeordnete Einheit
- 11: Gehäuse
- 12: Erstes Elektronik-Modul
- 13: Zweites Elektronik-Modul
- 14: Mechanische Befestigung
- 15: Elektrischer Steckkontakt
- 16: Zweite Leiterplatte
- 17: Flexible Leiterkarte
- 18: Verguss
- 19: Schwingfähiger Körper
- 111: Innenraum des Gehäuses
- 141: Einrast-Laschen
- 151: Stecker-Anordnung
- 152: Buchsen-Anordnung
- 153: Erste Leiterplatte
- 154: Leiterplatten-Aufnahme
- 1541: Führungsnuten der ersten Führung
- 1542: Endanschlags-Element
- 1543: Zweite Führung
- 1544: Bügel
- 1545: Einrast-Haken
- a: Einsteck-Vektor
- G: Grenzstand

## Patentansprüche

1. Feldgerät, umfassend:
- ein Gehäuse (11) mit einem Innenraum (111),
- ein im Innenraum (111) befestigtes, erstes Elektronik-Modul (12),
- ein im Innenraum (111) angeordnetes, zweites Elektronik-Modul (13),
- eine mechanische Befestigung (14), mittels der das zweite Elektronik-Modul (13) entlang eines definierten Einsteck-Vektors (a) an dem ersten Elektronik-Modul (12) befestigbar ist, und
- einen elektrischen Steckkontakt (15), über den das zweite Elektronik-Modul (13) korrespondierend zur mechanischen Verbindung (14) in Richtung des Einsteck-Vektors (a) elektrisch mit dem ersten Elektronik-Modul (12) kontaktierbar ist, mit
o einer Stecker-Anordnung (151),
o einer zur Stecker-Anordnung (151) korrespondierenden Buchsen-Anordnung (152), o einer ersten Leiterplatte (153) mit einer Oberfläche, auf welcher entweder die Stecker-Anordnung (151) oder die Buchsen-Anordnung (152) angeordnet ist, und
o einer Leiterplatten-Aufnahme (154), welche an einem der zwei Elektronik-Module (12, 13) integriert angeordnet ist,
wobei diejenige der zwei Anordnungen (151, 152), welche nicht an der ersten Leiterplatte (153) befestigt ist, entsprechend an demjenigen Elektronik-Modul (12, 13), an welchem nicht die Leiterplatten-Aufnahme (154) befestigt ist, angeordnet ist,
**dadurch gekennzeichnet,**
**dass** auf der Oberfläche der ersten Leiterplatte (153) entweder die Stecker-Anordnung (151) oder die Buchsen-Anordnung (152) derart angeordnet ist, dass die Stecker bzw. Buchsen parallel zur Oberfläche ausgerichtet sind, und
**dass** die Leiterplatten-Aufnahme (154) eine erste Führung (1541a, b) und zumindest ein Endanschlags-Element (1542a, b) aufweist,
wobei mittels der ersten Führung (1541a, b) die erste Leiterplatte (153) parallel zum Einsteck-Vektor (a) führbar ist, und
wobei das Endanschlags-Element (1542a, b) für die entsprechende Stecker- bzw. Buchsen-Anordnung (151, 152) auf der ersten Leiterplatte (153) in der ersten Führung (1541a, b) entgegen dem Einsteck-Vektor (a) einen Endanschlag ausbildet.

2. Feldgerät nach Anspruch 1,
wobei die Leiterplatten-Aufnahme (154) eine zweite Führung (1543a, b) aufweist, welche ausgelegt ist, die entsprechende Stecker- bzw. Buchsen-Anordnung (151, 152) in Bezug zur Oberfläche der ersten Leiterplatte (153) orthogonal zu führen.

3. Feldgerät nach Anspruch 1 oder 2,
wobei dasjenige Elektronik-Modul (12, 13), an welchem die Leiterplatten-Aufnahme (154) angeordnet ist, ein zweite Leiterplatte (16) umfasst, welche orthogonal zum Einsteck-Vektor (a) ausgerichtet ist,
wobei die Leiterplatten-Aufnahme (154) bzw. die entsprechende Anordnung (151, 152) in Bezug zum Einsteck-Vektor (a) hinter bzw. oberhalb der zweiten Leiterplatte (16) angeordnet ist,
wobei die Leiterplatten-Aufnahme (154) auf Seiten derjenigen Oberfläche der ersten Leiterplatte (153), auf welcher die entsprechende Anordnung (151, 152) angeordnet ist, einen orthogonal zum Einsteck-Vektor (a) verlaufenden Bügel (1544) aufweist, und
wobei diese Oberfläche der ersten Leiterplatte (153) elektrisch über eine flexible Leiterkarte oder ein flexibles Kabel mit der zweiten Leiterplatte (16) verbunden ist.

4. Feldgerät nach Anspruch 3,
wobei der Bügel (1544) in der Leiterplatten-Aufnahme (154) eine Innenfläche umschließt, welche kleiner als ein minimaler Umfang der entsprechenden Anordnung (151, 152) auf der ersten Leiterplatte (153) ist.

5. Feldgerät nach einem der Ansprüche 1 bis 4,
wobei die Leiterplatten-Aufnahme (154) gegenüberliegend zu derjenigen Oberfläche der ersten Leiterplatte (153), auf welcher die entsprechende Anordnung (151, 152) angeordnet ist, einen Einrast-Haken (1545) aufweist, sodass der Einrast-Haken (1545) für die erste Leiterplatte (153) nach Einrasten in der ersten Führung (1541a, b) in Richtung des Einsteck-Vektors (a) einen Endanschlag ausbildet, und
wobei der Einrast-Haken (1544) derart ausgelegt ist, um im eingerasteten Zustand orthogonal zu ihrer Oberfläche eine Druckkraft auf die erste Leiterplatte (153) auszuüben.

6. Feldgerät nach einem der Ansprüche 1 bis 5,
wobei die mechanische Befestigung (14) an den Elektronik-Modulen (12, 13) zumindest drei Einrast-Laschen (141a, b, c) und entsprechende Vorsprünge umfasst.

## Claims

1. A field device, comprising:
- A housing (11) with an interior space (111),
- a first electronic module (12) mounted in the interior space (111),
- a second electronic module (13) arranged in the interior space (111),
- a mechanical fixing (14), which can be used to mount the second electronic module (13) on the first electronic module (12) along a defined insertion vector (a), and
- an electronic plug contact (15), which can be used to electrically connect the second electronic module (13) to the first electronic module (12) corresponding to the mechanical connection (14) in the direction of the insertion vector (a), with
o a plug arrangement (151),
o a socket arrangement (152) corresponding to the plug arrangement (151),
o a first PCB (153) with a surface on which either the plug arrangement (151) or the socket arrangement (152) is arranged, and
o a PCB mount (154), which is arranged integrated on one of the two electronic modules (12, 13),
wherein, of the two arrangements (151, 152), the one which is not mounted on the first PCB (153) is correspondingly arranged on the electronic module (12, 13) on which the PCB mount (154) is not mounted,
**characterized in that**
either the plug arrangement (151) or the socket arrangement (152) is arranged on the surface of the first PCB (153) in such a way that the plugs or sockets are aligned parallel to the surface, and
the PCB mount (154) has a first guide (1541a, b) and at least one limit stop element (1542a, b),
wherein the first PCB (153) can be guided parallel to the insertion vector (a) using the first guide (1541a, b), and
wherein the limit stop element (1542a, b) for the corresponding plug or socket arrangement (151, 152) on the first PCB (153) in the first guide (1541a, b) forms a limit stop against the insertion vector (a).

2. The field device as claimed in claim 1,
wherein the PCB mount (154) has a second guide (1543a, b), which is configured to guide the corresponding plug or socket arrangement (151, 152) orthogonally relative to the surface of the first PCB (153).

3. The field device as claimed in claim 1 or 2,
wherein the electronic module (12, 13), on which the PCB mount (154) is arranged comprises a second PCB (16), which is aligned orthogonally relative to the insertion vector (a),
wherein the PCB mount (154) or the corresponding arrangement (151, 152) is arranged behind or above the second PCB (16) relative to the insertion vector (a),
wherein the PCB mount (154), on the side of the surface of the first PCB (153) on which the corresponding arrangement (151, 152) is arranged, has a bracket (1544) running orthogonally relative to the insertion vector (a), and
wherein this surface of the first PCB (153) is electrically connected to the second PCB (16) via a flexible PCB or a flexible cable.

4. The field device as claimed in claim 3,
wherein the bracket (1544) in the PCB mount (154) surrounds an inner surface which is smaller than a minimum circumference of the corresponding arrangement (151, 152) on the first PCB (153).

5. The field device as claimed in one of claims 1 to 4,
wherein the PCB mount (154) opposite the surface of the first PCB (153) on which the corresponding arrangement (151, 152) is arranged has a snap-in hook (1545) so that the snap-in hook (1545) for the first PCB (153) forms a limit step in the direction of the insertion vector (a) after snapping into the first guide (1541a, b), and
wherein the snap-in hook (1544) is configured to exert a compressive force on the first PCB (153) when snapped in orthogonally relative to its surface.

6. The field device as claimed in one of claims 1 to 5,
wherein the mechanical fixing (14) on the electronic modules (12, 13) comprises at least three snap-in lugs (141a, b, c) and corresponding projecting parts.

## Revendications

1. Appareil de terrain, comprenant :
- un boîtier (11) avec un espace intérieur (111),
- un premier module électronique (12) fixé dans l'espace intérieur (111),
- un deuxième module électronique (13) disposé dans l'espace intérieur (111),
- une fixation mécanique (14) au moyen de laquelle le deuxième module électronique (13) peut être fixé au premier module électronique (12) le long d'un vecteur d'insertion défini (a), et
- un contact électrique enfichable (15) par l'intermédiaire duquel le deuxième module électronique (13) peut être mis en contact électrique avec le premier module électronique (12) dans le sens du vecteur d'insertion (a) de manière correspondante à la liaison mécanique (14), avec
∘ un agencement de connecteurs mâles (151),
∘ un agencement de connecteurs femelles (152) correspondant à l'agencement de connecteurs mâles (151),
∘ une première carte de circuit imprimé (153) avec une surface sur laquelle est disposé soit l'agencement de connecteurs mâles (151), soit l'agencement de connecteurs femelles (152), et
∘ un support de carte de circuit imprimé (154), lequel est disposé et intégré sur l'un des deux modules électroniques (12, 13),
l'un des deux agencements (151, 152) qui n'est pas fixé à la première carte de circuit imprimé (153) étant disposé de manière correspondante sur le module électronique (12, 13) auquel le support de carte de circuit imprimé (154) n'est pas fixé,
**caractérisé**
**en ce que**, sur la surface de la première carte de circuit imprimé (153), est disposé soit l'agencement de connecteurs mâles (151), soit l'agencement de connecteurs femelles (152), de telle sorte que les connecteurs mâles ou femelles soient orientés parallèlement à la surface, et
**en ce que** le support de carte de circuit imprimé (154) présente un premier guide (1541a, b) et au moins un élément de butée d'extrémité (1542a, b),
le premier guide (1541a, b) permettant de guider la première carte de circuit imprimé (153) parallèlement au vecteur d'insertion (a), et
l'élément de butée d'extrémité (1542a, b) pour l'agencement correspondant de connecteurs mâles ou femelles (151, 152) sur la première carte de circuit imprimé (153) dans le premier guide (1541a, b) forme une butée d'extrémité opposée au vecteur d'insertion (a).

2. Appareil de terrain selon la revendication 1,
pour lequel le support de carte de circuit imprimé (154) comporte un deuxième guide (1543a, b), lequel est conçu pour guider orthogonalement l'agencement correspondant de connecteurs mâles ou femelles (151, 152) par rapport à la surface de la première carte de circuit imprimé (153).

3. Appareil de terrain selon la revendication 1 ou 2,
pour lequel le module électronique (12, 13) sur lequel est disposé le support de carte de circuit imprimé (154) comprend une deuxième carte de circuit imprimé (16), laquelle est orientée orthogonalement au vecteur d'insertion (a),
le support de carte de circuit imprimé (154) ou l'agencement correspondant (151, 152) étant disposé derrière ou au-dessus de la deuxième carte de circuit imprimé (16) par rapport au vecteur d'insertion (a),
le support de carte de circuit imprimé (154) présentant, du côté de la surface de la première carte de circuit imprimé (153) sur laquelle est disposé l'agencement correspondant (151, 152), un étrier (1544) orthogonal au vecteur d'insertion (a), et cette surface de la première carte de circuit imprimé (153) étant reliée électriquement à la deuxième carte de circuit imprimé (16) par l'intermédiaire d'une carte de circuit imprimé flexible ou d'un câble flexible.

4. Appareil de terrain selon la revendication 3,
pour lequel l'étrier (1544) dans le support de carte de circuit imprimé (154) entoure une surface intérieure qui est plus petite qu'un pourtour minimal de l'agencement correspondant (151, 152) sur la première carte de circuit imprimé (153).

5. Appareil de terrain selon l'une des revendications 1 à 4,
pour lequel le support de carte de circuit imprimé (154) présente, à l'opposé de la surface de la première carte de circuit imprimé (153) sur laquelle est disposé l'agencement correspondant (151, 152), un crochet d'encliquetage (1545) de telle sorte que le crochet d'encliquetage (1545) forme une butée d'extrémité pour la première carte de circuit imprimé (153) après encliquetage dans le premier guide (1541a, b) dans la direction du vecteur d'insertion (a), et
le crochet d'encliquetage (1544) étant conçu de manière à exercer, à l'état encliqueté, une force de pression sur la première carte de circuit imprimé (153) orthogonalement à sa surface.

6. Appareil de terrain selon l'une des revendications 1 à 5,
pour lequel la fixation mécanique (14) sur les modules électroniques (12, 13) comprend au moins trois languettes d'encliquetage (141 a, b, c) et des saillies correspondantes.
